(19) **Europäisches Patentamt European Patent Office Office européen des brevets**

(11) **EP 2 950 626 B1**

(12) **EUROPEAN PATENT SPECIFICATION**

(45) Date of publication and mention of the grant of the patent:
**20.02.2019 Bulletin 2019/08**

(51) Int Cl.:
***H05K 7/20*** *(2006.01)*

(21) Application number: **15167319.1**

(22) Date of filing: **12.05.2015**

(54) **ERROR DETECTION SYSTEM FOR COOLING APPARATUS**

**FEHLERERKENNUNGSSYSTEM FÜR KÜHLVORRICHTUNG**

**SYSTÈME DE DÉTECTION D'ERREUR POUR APPAREIL DE REFROIDISSEMENT**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.05.2014 JP 2014110875**

(43) Date of publication of application:
**02.12.2015 Bulletin 2015/49**

(73) Proprietor: **Hitachi, Ltd.**
**Chiyoda-ku**
**Tokyo 100-8280 (JP)**

(72) Inventors:
• **Suzuki, Osamu**
**Tokyo 100-8280 (JP)**
• **Iihoshi, Yoichi**
**Tokyo 100-8280 (JP)**
• **Furutani, Ryo**
**Tokyo 100-8280 (JP)**

(74) Representative: **Mewburn Ellis LLP**
**City Tower**
**40 Basinghall Street**
**London EC2V 5DE (GB)**

(56) References cited:
**JP-A- 2011 216 718**

**Description**

BACKGROUND OF THE INVENTION

1. Field of the Invention

The present invention relates to an error detection system for detecting the aging of cooling apparatuses.

2. Description of the Related Art

Technologies for providing condition-based maintenance have been progressively studied to improve the efficiency of mechanical product maintenance. In the condition-based maintenance, the condition of an apparatus is diagnosed from condition data (sensor value and control value) about the apparatus, and actual maintenance is performed on the apparatus on the basis of the diagnosis results.

In particular, if a moving vehicle, such as a railroad car, a monorail car, or other railroad vehicle, has to stop due to its error, this stop will have a great impact on many passengers. Therefore, it is strongly demanded that technological development be achieved to provide the condition-based maintenance in which various apparatuses in the moving vehicle, after being diagnosed from the condition data (senor value and control value) about the vehicle to check for aging, are inspected and serviced as needed on the basis of the diagnosis result.

If an error has found in a cooling apparatus, a power converter, which is mounted in a moving vehicle and used as a driving source, may not only run an increasing risk of suffering thermal runaway but also cause physical destruction of circuitry due to a sudden temperature change. Thus, the error of the cooling apparatus may immediately lead to an emergency stop of the moving vehicle. Such being the case, a technology proposed in JP-2013-011179-A, which is related to condition-based maintenance of such a cooling apparatus, provides an error detector for a cooling system for a power converter of a hybrid vehicle or an electric vehicle, for example. This error detector is configured so that a temperature sensor is mounted on two portions of a cooler to accurately detect an error.

Further, a technology proposed, for example, in JP-2011-216718-A, provides an electric vehicle power supply device that is capable of monitoring whether a cooler is stained. This electric vehicle power supply device includes a temperature detection section for an inverter, an external temperature detection section, and a current detection section for detecting an input current to a load in order to determine whether a cooling capacity is decreased.

SUMMARY OF THE INVENTION

Related-art technologies including those described above aim to accurately detect an error on the presumption that a cooling system is in a thermally steady state.

Therefore, the related-art technologies cannot make an accurate diagnosis by achieving early detection of the aging of a cooling apparatus designed for a power converter in which thermal load to be dissipated transiently changes, that is, by achieving early detection of, for example, heat exchange performance deterioration caused by a stain on a radiator included in a cooling apparatus that dissipates heat generated from a power converter for a railroad vehicle. Consequently, using the related-art technologies to detect an error may run the risk of missing the optimal timing for inspection, servicing, and maintenance.

The present invention has been made in view of the above circumstances and makes it possible to make an early, accurate diagnosis of performance deterioration of a cooling apparatus on the basis of the temperature of the cooling apparatus, an ambient air temperature, and current controlled by a power converter that directly affects the amount of heat generated from the power converter.

To address the above problem, the present invention provides an error detection system according to claim 1.

Further, the error detection system may store in a database in time-series the calculated thermal resistance and then calculate predictive information about the aging of performance of the cooling apparatus on the basis of the databased information.

Furthermore, when the power converter is mounted in a moving vehicle, the error detection system may include a communication system capable of operating so that signals input to the sensors are transmitted to a ground system. Thus, the estimated performance of the cooling apparatus and the information about the aging of the cooling apparatus may be derived from the ground system to which the communication system is connected.

The error detection system for a cooling device according to the present invention accurately estimates the performance of the cooling apparatus and the aging of a target, such as a railroad vehicle, that rarely enters a thermally steady state since the thermal load of the target generated from a power converter significantly varies during the operation of the target.

Other problems, configurations, and advantageous effects will become obvious from the following description of an embodiment of the present invention.

BRIEF DESCRIPTION OF THE DRAWINGS

Other objects and advantages of the invention will become apparent from the following description of embodiments with reference to the accompanying drawings in which:

FIG. 1 is a diagram illustrating a configuration of an error detection system according to an embodiment of the present invention and a configuration of a railroad system having the error detection system;
FIG. 2 is a diagram illustrating a modified configuration of the error detection system shown in FIG. 1 and a modified configuration of the railroad system having the error detection system;
FIG. 3 is a flowchart illustrating a process that is performed by the error detection system according to the embodiment of the present invention in order to determine an extraction start time for a cooling apparatus performance estimation data set;
FIG. 4 is a flowchart illustrating a process that is performed by the error detection system according to the embodiment of the present invention in order to determine an extraction end time for the cooling apparatus performance estimation data set;
FIG. 5 is a graph showing an example in which the error detection system according to the embodiment of the present invention extracts the cooling apparatus performance estimation data set; and
FIG. 6 is a graph that plots relationships between cumulative operating time and changes in thermal resistance, which is an estimated cooling apparatus performance index, in order to diagnose the aging of a cooling apparatus in the error detection system according to the embodiment of the present invention.

DESCRIPTION OF THE PREFERRED EMBODIMENTS

An embodiment of the present invention will now be described with reference to the accompanying drawings.

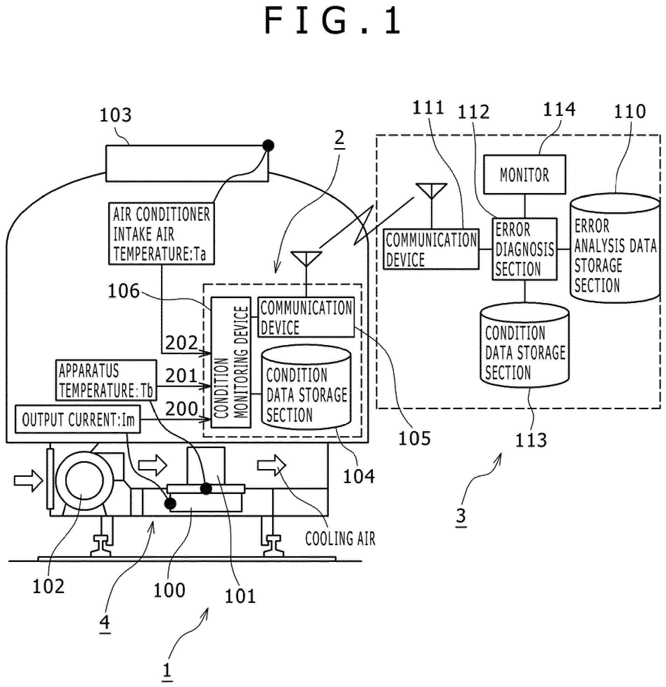

FIG. 1 shows an example of an error detection system according to the embodiment of the present invention that is used for a motor drive power converter and its cooling apparatus, which are mounted in a railroad vehicle. The error detection system according to the present invention will now be briefly explained with reference to FIG. 1.
A power converter 4 mounted beneath the floor of a railroad vehicle 1 uses a power conversion circuit 100 to supply electrical power to a railroad vehicle drive motor (not shown) . The amount of heat generated by the power conversion circuit 100 increases with an increase in an input/output current flowing between the power conversion circuit 100 and the motor.
An overheated power conversion circuit 100 may not only run an increasing risk of suffering thermal runaway but also receive physical damage because, for example, a circuit board is repeatedly subjected to violent thermal expansion and contraction due to a sudden temperature change. Such being the case, a cooling apparatus 101 is provided to cool the power conversion circuit 100 so that heat generated from circuit elements is dissipated to the outside of the railroad vehicle 1.
More specifically, the heat generated from the power conversion circuit 100 is transferred to the cooling apparatus 101. A cooling fan 102, which takes in outside air, then dissipates the heat transferred to the cooling apparatus 101 to the outside. As a result, the power conversion circuit 100 is cooled to a predetermined temperature so as not to have an excessive heat.
If the performance of the cooling apparatus 101 deteriorates, it will eventually be difficult to maintain the power conversion circuit 100 at a temperature not higher than the predetermined temperature. Thus, the aforementioned problem occurs. A first temperature sensor, a second temperature sensor, and a current sensor are provided to avoid the problem. The first temperature sensor measures a representative temperature (apparatus temperature Tb) of the cooling apparatus 101. The second temperature sensor measures an ambient air temperature (air-conditioner intake air temperature Ta). The current sensor measures an input/output current (input/output current Im) controlled by the power conversion circuit 100. An error diagnosis section 112 estimates the performance of the cooling apparatus 101 on the basis of the measured signals from the above-mentioned sensors.
The present embodiment will now be described in detail.
The cooling apparatus 101 includes a temperature sensor (first temperature sensor) that monitors its representative temperature Tb 201 and is disposed on or near the mounting surface of the power conversion circuit 100. In the present embodiment, the first temperature sensor is disposed between a base for mounting the power conversion circuit 100 and the cooling apparatus 101 and a joint surface of the power conversion circuit 100 to measure the representative temperature of the cooling apparatus 101.
Meanwhile, another temperature sensor (second temperature sensor) is mounted in the railroad vehicle 1 to monitor the ambient air temperature Ta 202, which is the temperature of outside air taken in by the cooling fan 102. In the present embodiment, an intake air temperature sensor equipped in an air conditioner 103 mounted in the railroad vehicle 1 is used as the second temperature sensor that measures the temperature of the outside air taken in by the cooling fan 102. Further, a current sensor is disposed in the power converter 4 to monitor a current value Im 200 of the input/output current flowing between the power converter 4 and the motor (not shown).

A vehicle-mounted data processing system 2 includes a condition monitoring device 106, a condition data storage section 104, and a communication device 105.

The condition monitoring device 106 inputs signals indicative of the cooling apparatus temperature Tb 201, the ambient air temperature Ta 202, and the input/output current 200, and stores the input signals in the condition data storage section 104 as time-series data. Simultaneously, the condition monitoring device 106 uses the input signals to estimate thermal resistance (a value indicative of a temperature increase caused by heat generated per unit time), which is a performance index of the cooling apparatus.

As the thermal resistance varies depending on the ambient air temperature, the extraction of data about the thermal resistance begins in thermal equilibrium in which the apparatus temperature Tb is substantially equal to the ambient air temperature Ta, as described later. Further, the thermal resistance is also affected by the rotational speed of the cooling fan. Therefore, the thermal resistance is corrected by use of a correction coefficient based on the rotational speed of the cooling fan.

The cooling fan is driven with various drive methods. It may be constantly rotated while the railroad vehicle is running, turned on and off in accordance with the apparatus temperature Tb, or controlled in a stepwise or continuous fashion to vary its rotational speed in keeping with the apparatus temperature Tb. Thus, the correction based on the rotational speed of the cooling fan may be made by referring to a correction coefficient in a map that is prepared by experiments or the like for each drive method.

As shown in FIG. 1, the thermal resistance may be estimated by the condition monitoring device 106 included in the vehicle-mounted data processing system 2. The estimated thermal resistance may then be transmitted to the error diagnosis section 112 in a ground data processing system 3 through the communication device 105 and completed in the ground data processing system 3.

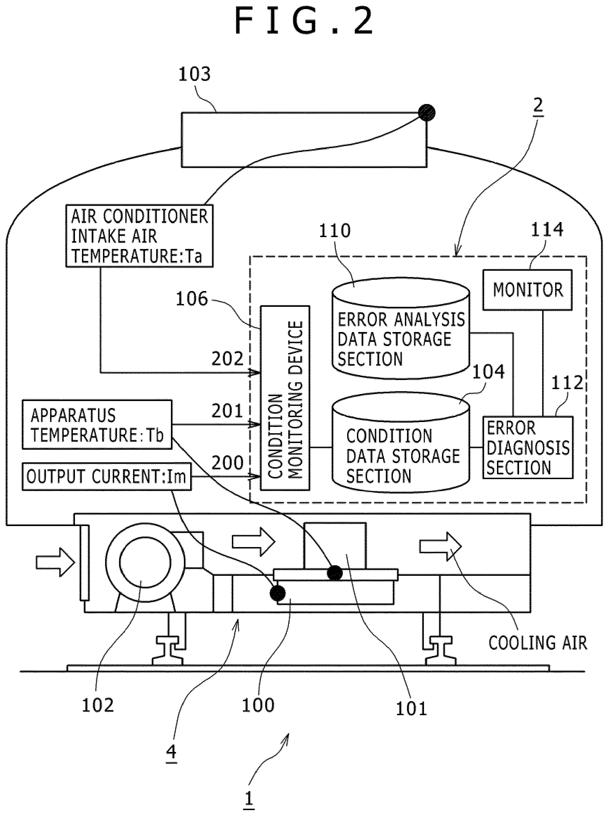

Alternatively, as shown in FIG. 2, all functions may be centralized in the vehicle-mounted data processing system 2 so as to cover railroad lines without the ground data processing system 3 for the purpose of allowing a vehicle-mounted error diagnosis section 112 to estimate the thermal resistance.

Another alternative, for example, is to mount only the temperature sensors, the current sensor, and the communication device on the railroad vehicle and centralize all the other elements in the ground data processing system 3. Devices and functions to be equipped to the vehicle-mounted data processing system or to the ground data processing system may be variously selected in accordance with an overall system configuration.

A case where the thermal resistance is calculated by the vehicle-mounted data processing system 2 as shown in FIG. 1 will be described below.

The thermal resistance calculated by the condition monitoring device 106 included in the vehicle-mounted data processing system 2 or the condition data stored in the condition data storage section 104 is transmitted to the ground data processing system 3 through a ground communication device 111. Since the aging of cooling performance is the target of error detection, the thermal resistance or the condition data are usually transmitted at times when the railroad vehicle enters a maintenance base.

If, for instance, sudden occurrence of an error of the cooling apparatus 101 because of a factor other than aging is to be detected and utilized for corrective maintenance, the vehicle-mounted data processing system 2 transmits error information in real time. Other factors can be a situation where the apparatus temperature Tb is close to the maximum permissible temperature of the power converter 4 due, for instance, to the breakage of a heat pipe used for the cooling apparatus 101.

The present embodiment is described on the assumption that a wireless transmission method is used. However, the method of transmission is not limited to it. For example, a communication cable may be used to achieve transmission as well.

The ground data processing system 3 includes the communication device 111, the error diagnosis section 112, a condition data storage section 113, an error analysis data storage section 110, and a monitor 114. Thermal resistance information that the communication device 111 receives from the vehicle-mounted data processing system 2 is not only stored in the condition data storage section 113 as time-series data, but also forwarded to the error diagnosis section 112 and used for error diagnosis.

If the calculated thermal resistance meets a determination condition defined by a predetermined threshold value or other ones, maintenance personnel is notified of the aging of the cooling apparatus 101 through, for example, the monitor 114 that displays relevant information. However, the monitor 114 is not an essential item. Alternatively, for example, a warning lamp, an alarm, or a printer that prints out the number of railroad vehicles in need of maintenance may be used to generate an output appropriate for maintenance and management.

The heat generated by the power converter 4 that drives a vehicle motor transiently changes in synchronism with motor load changes. Therefore, when the thermal resistance is estimated, data containing an appropriate time-series data set needs to be used for extraction.

The time-series data set appropriate for thermal resistance estimation is such that the beginning of data represents the instant at which thermal load input to the cooling apparatus starts in a situation where the amount of heat stored in the cooling apparatus is substantially zero when a railroad vehicle starts its daily operation, and that the end of the data represents the instant at which the heat applied to the cooling apparatus is no longer stored after the stop of the thermal load input.

Next, the method of extracting the time-series data set will be described.

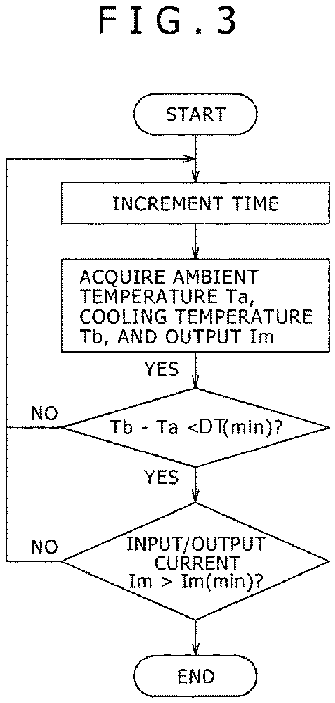

FIG. 3 is a flowchart illustrating a process performed to determine an extraction start time for a data set. At a certain point of time, it is determined whether the difference between the apparatus temperature Tb and the ambient air temperature Ta is smaller than a value DT(min) that can be regarded as being substantially zero. Further, a time at which the input/output current Im is greater than a value Im(min) that can be regarded as being substantially zero when the difference is smaller than the value DT(min) is set at the beginning of the data set, that is, set as the extraction start time for the data set. This ensures that data extraction can be started in accordance, for instance, with the ambient air temperature during the day of operation.

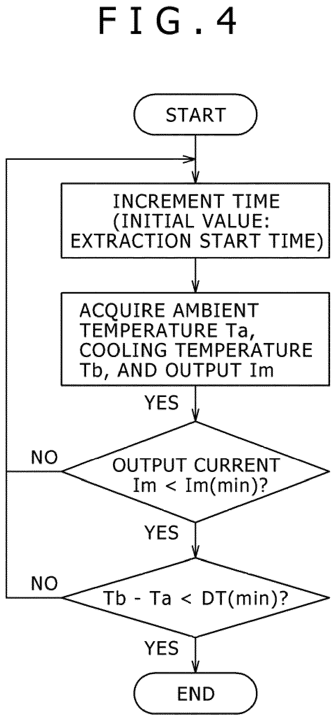

FIG. 4 is a flowchart illustrating a process performed to determine an extraction end time for a data set.

The extraction start time, which is set in accordance with the flowchart of FIG. 3, is updated to an initial value. At each point of time, it is determined whether the input/output current Im is smaller than the value Im(min) that can be regarded as being substantially zero. Further, a time at which the difference between the apparatus temperature Tb and the ambient air temperature Ta is smaller than the value DT(min) when the input/output current Im is smaller than the value Im(min) is set at the end of the data set, that is, set as the extraction end time for the data set.

The extraction end time need not always be limited to a situation where the difference between the apparatus temperature Tb and the ambient air temperature Ta is smaller than the value DT(min) that can be regarded as being substantially zero at the end of a day's operation of the railroad vehicle. The extraction end time may be variously set. For example, a time at which an operation has been stopped for a predetermined period of time or longer or a time at which the apparatus temperature Tb is not higher than a predetermined value may be set as the extraction end time.

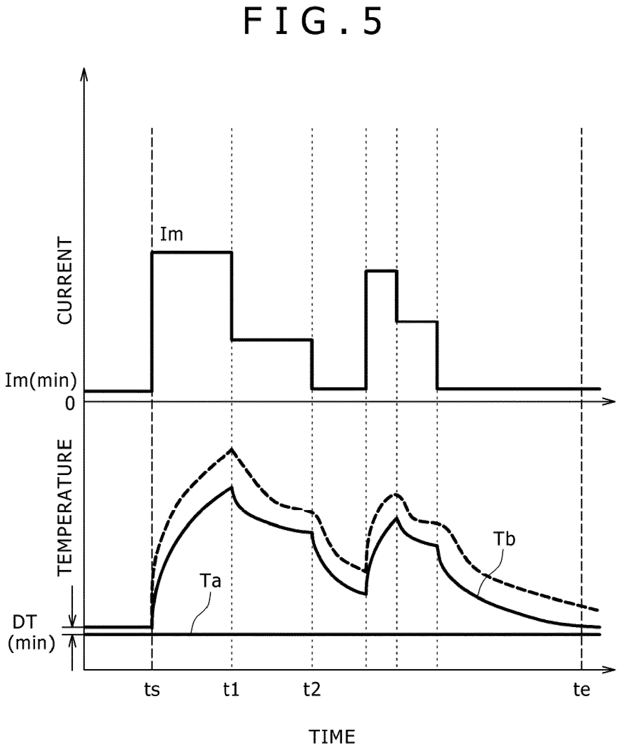

FIG. 5 shows an example of a time-series data set for thermal resistance estimation that is extracted on the basis of FIGS. 3 and 4. As shown in FIG. 5, the data set is in thermal equilibrium as the difference between the apparatus temperature Tb and the ambient air temperature Ta is substantially zero at its start time and end time. In the lower half of FIG. 5, a solid line represents a case where the cooling apparatus shows no sign of aging, and a broken line represents a case where the cooling apparatus shows a sign of aging.

A method of estimating a thermal resistance R from the time-series data set for thermal resistance estimation will now be described.

A temperature rise Tb - Ta between time ts and time t1, which is shown in FIG. 5, can be approximated by the following function:

$$
\text{Tb} - \text{Ta} = f(t) = k * \text{Im} * R * \{1 - \exp[-(t - ts)/(C * R)]\} \text{ --- (Equation 1)}
$$

where k is a constant that calculates the amount of heat generated by the power conversion circuit from the input/output current, and C is a constant indicative of the thermal capacity of the cooling apparatus. These constants are acquired in advance at a design stage of the apparatus.

Equation 1 is an expression indicating the interval between time ts and time t1. However, with the superposition principle being applied to it, a temperature rise between time ts and time te can also be described with a function based on Equation 1.

Therefore, when a computation result obtained from Equation 1 for each predetermined timing is subjected to curve fitting by using, for example, the least-square method, the thermal resistance R can be estimated.

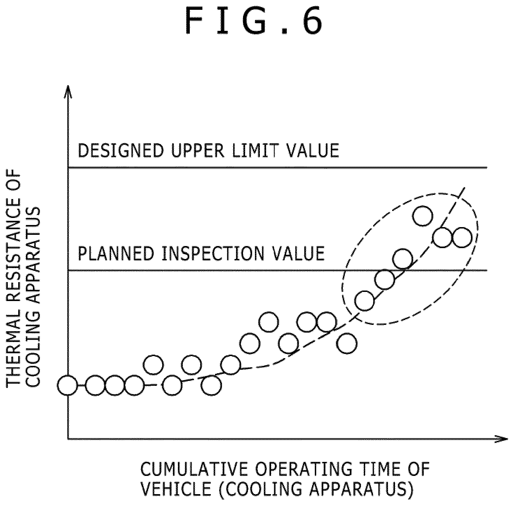

FIG. 6 is a graph that is obtained when the thermal resistance estimated through the above-described process is plotted by using the cumulative operating time of the vehicle as a parameter, the operating time being determined from a data set extraction date/time and an operation record of the vehicle.

In the present embodiment, a forced-air cooling system based on a cooling fan is employed as the cooling apparatus 101. It is conceivable that dirt and dust deposited on a heat exchanger disposed with respect to outside air may decrease the amount of air flowing to and the amount of heat transferred to the cooling apparatus 101. Thus, the thermal resistance of the cooling apparatus 101 may gradually increase with an increase in the operating time of the vehicle, thereby causing the cooling apparatus 101 to age.

FIG. 6 shows a representative tendency of aging caused by the above-described thermal resistance increase. As indicated by a region marked by the broken-line circle, the thermal resistance continues to gradually increase without decreasing until a planned inspection value is reached. This ensures that the tendency of aging can be certainly read before the thermal resistance reaches a designed upper limit value. The above-mentioned tendency of gradual increase can be significantly extracted by accurately estimating the thermal resistance as described in conjunction with the present embodiment. This makes it possible to accurately extract a sign of aging of performance of the cooling apparatus.

The foregoing embodiment has been described on the assumption that it is applied to a cooling apparatus for a power converter of a railroad vehicle. However, the present invention is also applicable to various cooling apparatuses, such as a cooling apparatus for a power converter of a moving vehicle including a hybrid vehicle and an electric vehicle in which the amount of heat generated by the power converter significantly varies in a transient fashion depending in particular on operational state.

It is to be noted that the present invention is not limited to the aforementioned embodiments, but covers various modifications. While, for illustrative purposes, those embodiments have been described specifically, the present invention is not necessarily limited to the specific forms disclosed. Thus, partial replacement is possible between the components of a certain embodiment and the components of another. Likewise, certain components can be added to or removed from the embodiments disclosed.

## Claims

1.  An error detection system for detecting an error in a cooling apparatus (101) mounted in a power converter (4) that drives, for example, a motor, the error detection system comprising:

    a first temperature sensor that measures a representative temperature (Tb) of the cooling apparatus,
    a second temperature sensor that measures an ambient air temperature (Ta), and
    a current sensor that measures an input/output current (Im) controlled by the power converter;
    wherein the error detection system is configured to:

    record measured signals sent from the first temperature sensor, the second temperature sensor, and the current sensor, respectively, as time-series data,
    extract from the recorded time-series data a data set, an extraction start time beginning the data of the data set being a time at which a difference between a measured temperature by the first temperature sensor and a measured temperature by the second temperature sensor is smaller than a minimum temperature difference (DT (min)), and also at which an input/output current value measured by the current sensor is greater than a minimum current value (Im(min)) and an extraction end time ending the data of the data set being a time at which the input/output current value measured by the current sensor is smaller than the minimum current value (Im(min)), and also at which the difference between the measured temperature by the first temperature sensor and the measured temperature by the second temperature sensor is smaller than the minimum temperature difference (DT(min)),
    calculate a thermal resistance of the cooling apparatus, on the basis of the extracted data set,
    detect an error in the cooling apparatus when the calculated thermal resistance reaches a planned inspection value.

2.  The error detection system according to claim 1, wherein:

    the calculated thermal resistance is stored in a database (104, 113) in time-series, and
    information about aging of the cooling apparatus is calculated on the basis of the databased information.

## Patentansprüche

1.  Fehlerdetektionssystem zum Detektieren eines Fehlers in einer Kühlvorrichtung (101), die in einem Leistungswandler (4) angebracht ist, der beispielsweise einen Motor ansteuert, wobei das Fehlerdetektionssystem Folgendes umfasst:

    einen ersten Temperatursensor, der eine repräsentative Temperatur (Tb) der Kühlvorrichtung misst,
    einen zweiten Temperatursensor, der eine Umgebungslufttemperatur (Ta) misst, und
    einen Stromsensor, der einen vom Leistungswandler gesteuerten Eingangs-/Ausgangs-Strom (Im) misst;
    wobei das Fehlerdetektionssystem für Folgendes konfiguriert ist:

    Aufzeichnen von gemessenen Signalen, die von dem ersten Temperatursensor, dem zweiten Temperatursensor und dem Stromsensor jeweils als Zeitreihendaten gesendet werden,

Extrahieren einer Datenmenge aus den aufgezeichneten Zeitreihendaten,

wobei ein Extraktionsstartzeitpunkt, an dem die Daten der Datenmenge beginnen, ein Zeitpunkt ist, zu dem eine Differenz zwischen einer von dem ersten Temperatursensor gemessenen Temperatur und einer von dem zweiten Temperatursensor gemessenen Temperatur kleiner als eine Minimaltemperaturdifferenz (DT(min)) ist,

und auch zu dem ein durch den Stromsensor gemessener Eingangs-/Ausgangs-Stromwert größer als ein Minimalstromwert (Im(min)) ist, und

wobei ein Extraktionsendzeitpunkt, an dem die Daten der Datenmenge enden, ein Zeitpunkt ist, zu dem der von dem Stromsensor gemessene Eingangs-/Ausgangs-Stromwert kleiner als der Minimalstromwert (Im(min)) ist,

und auch zu dem die Differenz zwischen der von dem ersten Temperatursensor gemessenen Temperatur und der von dem zweiten Temperatursensor gemessenen Temperatur kleiner als die Minimaltemperaturdifferenz (DT(min)) ist,

Berechnen eines Wärmewiderstands der Kühlvorrichtung auf Basis der extrahierten Datenmenge,

Detektieren eines Fehlers in der Kühlvorrichtung, wenn der berechnete Wärmewiderstand einen geplanten Prüfwert erreicht.

2. Fehlerdetektionssystem gemäß Anspruch 1,

wobei der berechnete Wärmewiderstand in einer Datenbank (104, 113) in Zeitreihen gespeichert ist, und

wobei Informationen über ein Altern der Kühlvorrichtung auf Basis der Datenbank-Informationen berechnet wird.

## Revendications

1. Système de détection d'erreur pour détecter une erreur dans un appareil de refroidissement (101) monté dans un convertisseur de puissance (4) qui entraîne, par exemple, un moteur, le système de détection d'erreur comprenant :

un premier capteur de température qui mesure une température représentative (Tb) de l'appareil de refroidissement,

un second capteur de température qui mesure une température d'air ambiant (Ta), et

un capteur de courant qui mesure un courant d'entrée/de sortie (Im) commandé par le convertisseur de puissance ;

dans lequel le système de détection d'erreur est configuré pour :

enregistrer des signaux mesurés envoyés à partir du premier capteur de température, du second capteur de température, et du capteur de courant, respectivement, en tant que données en séries chronologiques,

extraire à partir des données en séries chronologiques enregistrées un ensemble de données, un moment de début d'extraction marquant le commencement des données de l'ensemble de données étant un moment auquel une différence entre une température mesurée par le premier capteur de température et une température mesurée par le second capteur de température est inférieure à une différence de température minimale (Dt(min)), et également auquel une valeur de courant d'entrée/de sortie mesurée par le capteur de courant est supérieure à une valeur de courant minimale (Im(min)), et un moment de fin d'extraction marquant la fin des données de l'ensemble de données étant un moment auquel la valeur de courant d'entrée/de sortie mesurée par le capteur de courant est inférieure à la valeur de courant minimale (Im(min)), et également auquel la différence entre la température mesurée par le premier capteur de température et la température mesurée par le second capteur de température est inférieure à la différence de température minimale (Dt(min)),

calculer une résistance thermique de l'appareil de refroidissement, sur la base de l'ensemble de données extraites,

détecter une erreur dans l'appareil de refroidissement lorsque la résistance thermique calculée atteint une valeur d'inspection prévue.

2. Système de détection d'erreur selon la revendication 1, dans lequel :

la résistance thermique calculée est stockée dans une base de données (104, 113) en séries chronologiques, et des informations concernant le vieillissement de l'appareil de refroidissement sont calculées sur la base des informations basées sur les données.

# FIG.1

# FIG.2

103

2

AIR CONDITIONER INTAKE AIR TEMPERATURE:Ta

110

114

MONITOR

106

CONDITION MONITORING DEVICE

ERROR ANALYSIS DATA STORAGE SECTION

202

104

112

APPARATUS TEMPERATURE:Tb

201

CONDITION DATA STORAGE SECTION

ERROR DIAGNOSIS SECTION

OUTPUT CURRENT:Im

200

COOLING AIR

102

100

101

4

1

# FIG.3

```
        ┌─────────┐
        │  START  │
        └─────────┘
             │
             ▼
  ┌────────────────────────┐
  │     INCREMENT TIME     │
  └────────────────────────┘
             │
             ▼
  ┌────────────────────────┐
  │  ACQUIRE AMBIENT       │
  │  TEMPERATURE Ta,       │
  │  COOLING TEMPERATURE   │
  │  Tb, AND OUTPUT Im     │
  └────────────────────────┘
           YES │
               ▼
  NO      ◇ Tb - Ta <DT(min)? ◇
           YES │
               ▼
  NO      ◇ INPUT/OUTPUT
            CURRENT
            Im > Im(min)? ◇
               │
               ▼
        ┌─────────┐
        │   END   │
        └─────────┘
```

10

# FIG.4

START

↓

INCREMENT TIME
(INITIAL VALUE:
EXTRACTION START TIME)

↓

ACQUIRE AMBIENT
TEMPERATURE Ta,
COOLING TEMPERATURE
Tb, AND OUTPUT Im

YES ↓

OUTPUT CURRENT
Im < Im(min)?

NO ←

YES ↓

Tb - Ta < DT(min)?

NO ←

YES ↓

END

# FIG.5

# FIG.6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013011179 A
- JP 2011216718 A